# EUROPEAN PATENT APPLICATION

(11) **EP 2 506 323 A2**
(43) Date of publication of application: **03.10.2012**
(21) Application number: 12159808.0
(22) Date of filing: 16.03.2012
(51) Int. Cl.: H01L 35/30

(54) **Thermoelectric conversion unit and method of manufacturing**

(30) Priority: 29.03.2011 JP 2011071713
(71) Applicant: Kabushiki Kaisha Toyota Jidoshokki, Kariya-shi, Aichi 448-8671 (JP)
(72) Inventor: Okuda, Motoaki, Kariya-shi, Aichi 448-8671 (JP); Yokomachi, Naoya, Kariya-shi, Aichi 448-8671 (JP); Ueda, Hiromi, Kariya-shi, Aichi 448-8671 (JP); Nakamura, Junki, Kariya-shi, Aichi 448-8671 (JP)
(74) Representative: TBK

(57) **Abstract**

One aspect of the present invention includes a thermoelectric conversion unit (1) having a case (4) in which a flow path (4a2) of an open structure is molded, a first substrate (2b) covering an open portion of the flow path (4a2), a second substrate (2c) arranged opposite the first substrate (2b), and a plurality of thermoelectric conversion elements (2a) arranged between the first substrate (2b) and the second substrate (2c). At a bottom surface of the flow path (4a2) of the case (4), an introduction pipe (4b) and a discharge pipe (4c) are formed integrally with the case (4), and each of the introduction and discharge pipes (4b, 4c) extend in a direction perpendicular to the first substrate (2b).

## Description

This application claims priority to Japanese patent application serial number 2011-71713, the contents of which are incorporated herein by reference.

The present invention relates to a thermoelectric conversion unit having a thermoelectric conversion element.

The thermoelectric conversion unit disclosed in Japanese Patent Application No. 2001-4245 consists of a thermoelectric conversion module and a case covering one side of the thermoelectric conversion module. The thermoelectric conversion module contains a thermoelectric conversion element equipped with a pair of heat surfaces and a plate member held in contact with one of the heat surfaces. The case has an open structure flow path with an open portion of the flow path being covered with a plate member. The case is provided with an introduction pipe and a discharge pipe extending parallel to the plate member, each extending from a side surface of the case. A heat medium is introduced into the flow path from the introduction pipe and is discharged from the flow path via the discharge pipe.

However, the thermoelectric conversion unit disclosed in Japanese Patent Application Laid-Open No. 2001-4245 requires operations such as the connection of the introduction pipe and the discharge pipe to the case, resulting in a rather difficult manufacturing operation. Thus, there exists the need for a thermoelectric conversion unit that can be easily manufactured.

One aspect of the present invention includes a thermoelectric conversion unit having a case in which a flow path of an open structure is molded, a first substrate covering an open portion of the flow path, a second substrate arranged opposite the first substrate, and a plurality of thermoelectric conversion elements arranged between the first substrate and the second substrate. At a bottom surface of the flow path of the case, an introduction pipe and a discharge pipe are formed integrally with the case. The introduction and discharge pipes extend in a direction perpendicular to the first substrate.

In one embodiment, an opening direction of the flow path, as well as, the extending directions of the introduction and discharge pipes are the same. Thus, the case can be molded through the opening and closing of a pair of molds without having to use a slide mold. In this manner, the case can be easily manufactured. A heat medium, which is introduced into the flow path from the introduction pipe, flows toward the first substrate. The heat medium increases in flow rate in the vicinity of the first substrate near the thermoelectric conversion elements, making it possible to efficiently perform heat exchange with the thermoelectric conversion elements.

Additional objects, features, and advantages, of the present invention will be readily understood after reading the following detailed description together with the claims and the accompanying drawings, in which:
FIG. 1 is a configuration diagram of a heat exchange system;
FIG. 2 is a perspective view of a thermoelectric conversion unit;
FIG. 3 is an exploded perspective view of the thermoelectric conversion unit with the top section (second case 5) shown upside-down;
FIG. 4 is a cross-sectional view of a part of Fig. 2, taken along line IV-IV;
FIG. 5 is an exploded perspective view of a part of a thermoelectric conversion module;
FIG. 6 is an inverted perspective view of the lower half of the thermoelectric module;
FIG. 7 is a cross-sectional view of a part of Fig. 2, taken along line VII-VII;
FIG. 8 is a cross-sectional view of a part of Fig. 2, taken along line VIII-VIII;
FIG. 9 is a cross-sectional view of a part of Fig. 8, taken along line IX-IX;
FIG. 10 is a view showing a format of a case of an alternative embodiment; and
FIG. 11 is a view showing a format of a case of another alternative embodiment.

Each of the additional features and teachings disclosed above and below may be utilized separately or in conjunction with other features and teachings to provide improved thermoelectric conversion units or methods of manufacturing thereof. Representative examples of the present invention, which examples utilize many of these additional features and teachings both separately and in conjunction with one another, will now be described in detail with reference to the attached drawings. This detailed description is merely intended to teach a person of ordinary skill in the art further details for practicing preferred aspects of the present teachings and is not intended to limit the scope of the invention. Only the claims define the scope of the claimed invention. Therefore, combinations of features and steps disclosed in the following detailed description may not be necessary to practice the invention in the broadest sense, and are instead taught merely to particularly describe representative examples of the invention. Moreover, various features of the representative examples and the dependent claims may be combined in ways that are not specifically enumerated in order to provide additional useful configurations of the present teachings.

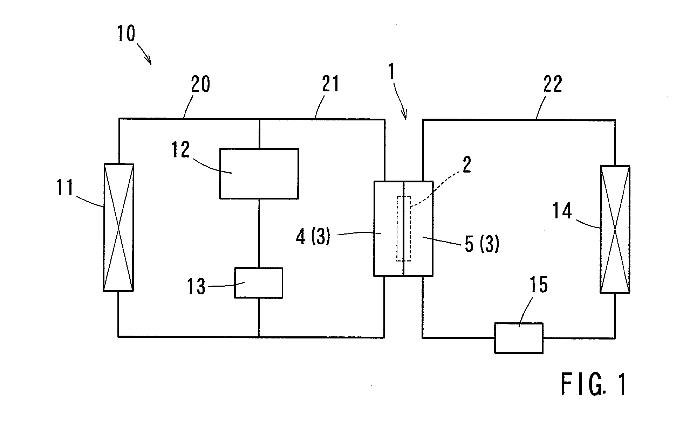

An embodiment of the present invention will be described with reference to Figs. 1 to 9. As shown in Fig. 1, a heat exchange system 10 is provided, for example, in a vehicle, and has a thermoelectric conversion unit 1, a radiator 11, and an indoor warm/cool unit 14. The radiator 11 is connected to a vehicle engine 12 by piping 20. A first heat medium (liquid coolant) is circulated between the engine 12 and the radiator 11 by a pump provided at a section in the piping 20. The first heat medium receives heat from the engine 12 and radiates the heat to the atmosphere from the radiator 11.

As shown in Fig. 1, a thermoelectric conversion unit 1 is connected to the radiator 11 by piping 21 and piping 20. The thermoelectric conversion unit 1 is connected in parallel to the radiator 11 and the engine 12. The first heat medium is cooled by the thermoelectric conversion unit 1 via the piping 20, 21. Thus, the first heat medium can be cooled not only by the radiator 11 but also by the thermoelectric conversion unit 1.

As shown in Fig. 1, the thermoelectric conversion unit 1 is connected to the indoor warm/cool unit 14 by piping 22. A second heat medium (liquid coolant) is circulated between the thermoelectric conversion unit 1 and the indoor warm/cool unit 14 by a pump 15 provided at a section in the piping 22. The second heat medium receives warm heat from the thermoelectric conversion unit 1 and radiates heat to the air in the room from the indoor warm/cool unit 14. Thus, the indoor warm/cool unit 14 can heat up the interior of the room.

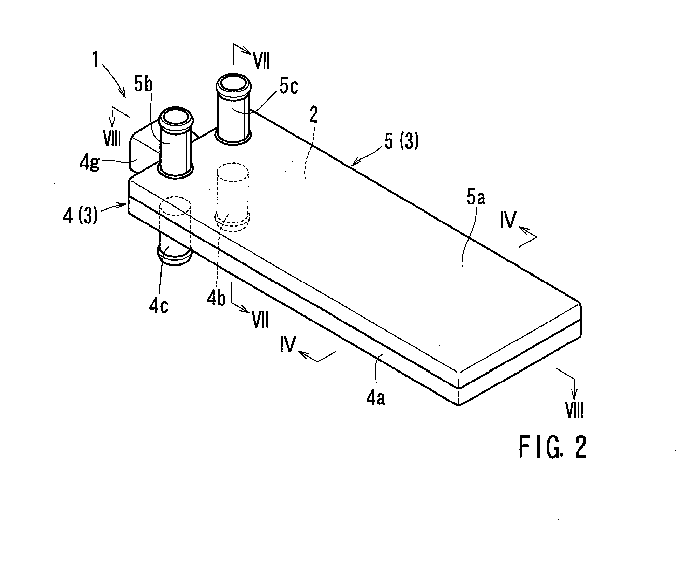

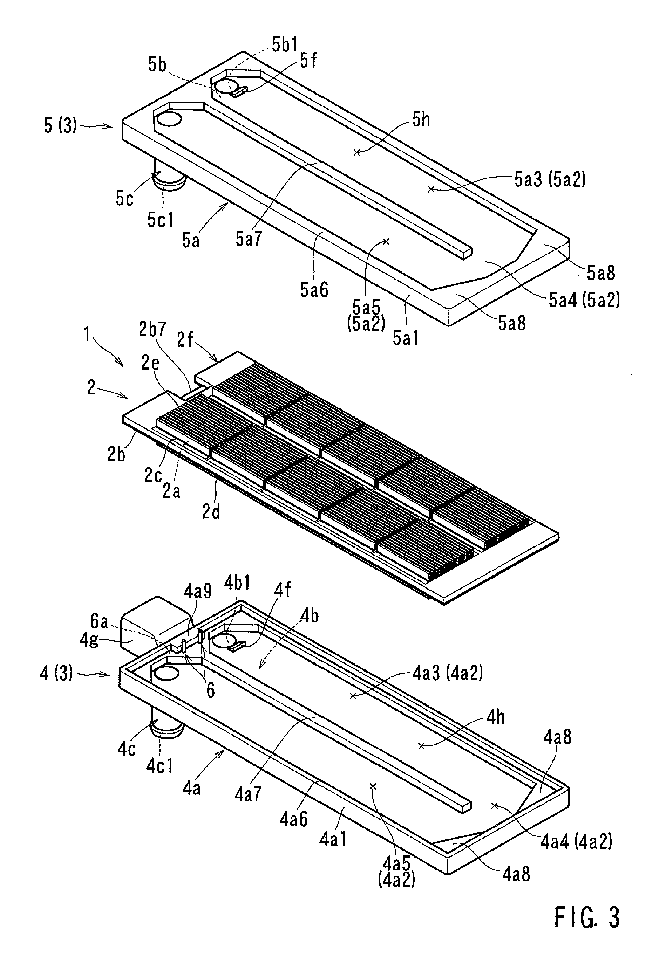

As shown in Figs. 2 and 3, the thermoelectric conversion unit 1 has a housing 3 and a thermoelectric conversion module 2 provided in the housing 3. The housing 3 has a first case 4 and a second case 5 stacked vertically. It must be noted that the second case 5 is shown upside-down in Fig. 3.

As shown in Figs. 2 and 3, the first case 4 is molded, integrally has a case main body 4a, an introduction pipe 4b and discharge pipe 4c. The case main body 4a has a plate portion 4a1 and a peripheral wall portion 4a6 protruding from the outer periphery of the plate portion 4a1. The first case 4 has an open structure and a flow path 4a2 in the plate portion 4a1. The flow path 4a2 opens to a thermoelectric conversion module 2, forming a recess 4h in the plate portion 4a1. A second case 5 is molded, and integrally has a case main body 5a, an introduction pipe 5b and a discharge pipe 5c. The case main body 5a has a plate portion 5a1 and a peripheral wall portion 5a6 protruding from the outer periphery of the plate portion 5a1. The second case 5 has an open structure and a flow path 5a2 in the plate portion 5a1. The flow paths 5a2 opens to the thermoelectric conversion module 2, forming a recess 5h in the plate portion 5a1.

As shown in Fig. 3, the flow paths 4a2 and 5a2, respectively, are divided by partition portions 4a7 and 5a7 formed on the plate portions 4a1 and 5a1. The flow paths 4a2 and 5a2, respectively, extend in a U-shape from first flow paths 4a3 and 5a3, into turnaround flow paths 4a4 and 5a4, and into second flow paths 4a5 and 5a5. Guide portions 4a8 and 5a8, respectively, protrude into the turnaround flow paths 4a4 and 5a4 from the plate portions 4a1 and 5a1. The guide portions 4a8 and 5a8, respectively, have inclined surfaces inclined toward flow paths 4a3, 4a5, 5a3, and 5a5. The guide portions 4a8 and 5a8 lie adjacently to the opposing flow paths 4a3, 4a5, 5a3, and 5a5. Due to the guide portions 4a8 and 5a8, a heat medium can smoothly flow from the first flow paths 4a3 and 5a3 to the second flow paths 4a5 and 5a5.

As shown in Fig. 3, the introduction pipe 4b and the discharge pipe 4c may be provided adjacently at one end of the plate portion 4a1. Introduction pipe 5b and discharge pipe 5c may be provided adjacently at one end of the plate portion 5a1. The introduction pipe 4b and 4c extend from the plate portion 4a1. Introduction pipe 5b and discharge pipe 5c extend from the plate portion 5a1. The introduction pipes 4b, 5b and discharge pipes 4c, 5c extend away from the thermoelectric conversion unit 2. The introduction pipes 4b, 5b, respectively, have introduction paths 4b1 and 5b1 communicating with the bottom surfaces of the first flow paths 4a3 and 5a3. Introduction path 4b1 passes through plate portion 4a1 and introduction pipe 4b. Introduction path 5b1 passes through plate portion 5a1 and introduction pipe 5b.

Discharge pipe 4c has a discharge path 4c1 communicating with the bottom surface of the second flow path 4a5. Discharge pipe 5c has a discharge path 5c1 communicating with the bottom surface of the second flow path 5a5. Discharge path 4c1 passes through plate portion 4a1 and the discharge pipe 4c. Discharge path 5c1 passes through the plate portion 5a1 and the discharge pipe 5c.

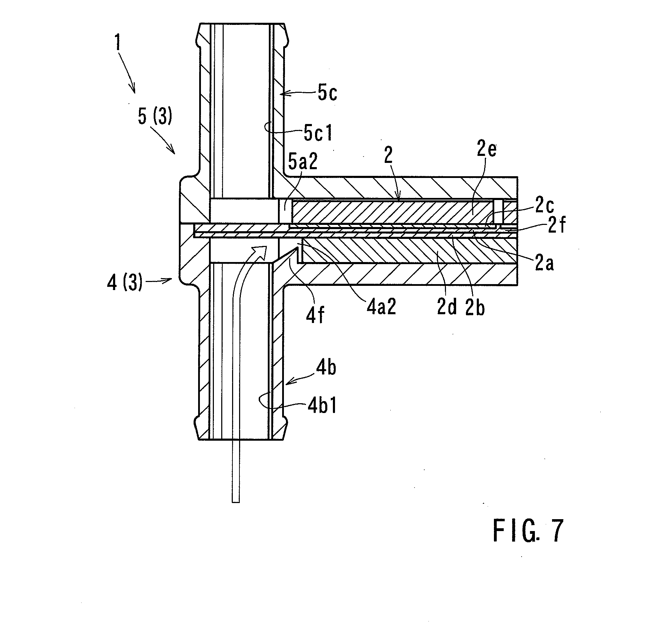

As shown in Figs. 3 and 7, the case main body 4a has a protruding portion 4f protruding into the flow path 4a2. Case main body 5a has a protruding portion 5f protruding into the flow path 5a2. The protruding portions 4f and 5f, respectively, protrude toward the substrates 2b and 2c of the thermoelectric conversion module 2. Protruding portion 4f has an inclined surface approaching the substrate 2b as it extends away from the introduction path 4b1. The protruding portion 5f has an inclined surface approaching the substrate 2c as it extends away from the introduction path 5b1. Thus, the heat medium introduced from the introduction path 4b1 flows toward substrate 2b and increases in flow rate in the vicinity of the substrate 2b. The heat medium introduced from the introduction path 5b1 flows toward the substrate 2c and increases in flow rate in the vicinity of the substrate 2c.

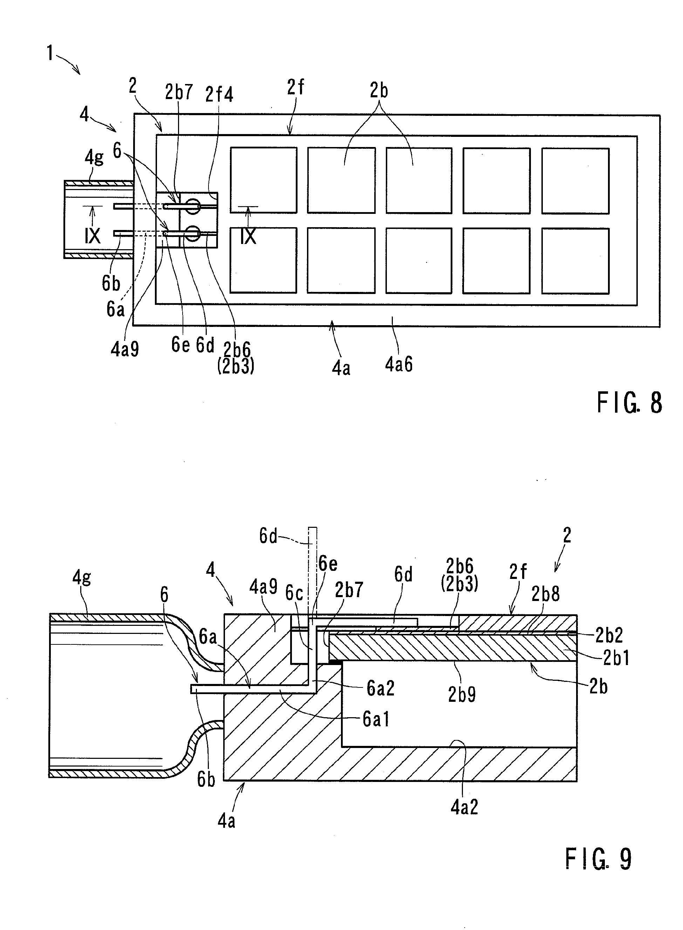

As shown in Figs. 3 and 9, the first case 4 integrally has a connector portion 4g. The connector portion 4g is tubular and protrudes sidewise from the case main body 4a. A connector portion of a converter (not shown) is connected to the connector portion 4g. The converter converts a voltage input to the converter to a predetermined voltage and supplies a DC current to the thermoelectric conversion module 2 via electrode members 6 provided in the first case 4.

As shown in Figs. 3 and 9, the first case 4 integrally has a positioning portion 4a9. The positioning portion 4a9 protrudes from a peripheral wall portion 4a6 and protrudes into a recess 2b7 of the thermoelectric module 2. Thus, the position of the thermoelectric conversion module 2 with respect to the first case 4 can be determined by the positioning portion 4a9.

By closing first and second molds (not shown), filling the space between the first and second molds with a resin material, and opening the first and second molds, the cases 4 and 5 allow integral molding of the case main bodies 4a and 5a, the introduction pipes 4b and 5b, and the discharge pipes 4c and 5c.

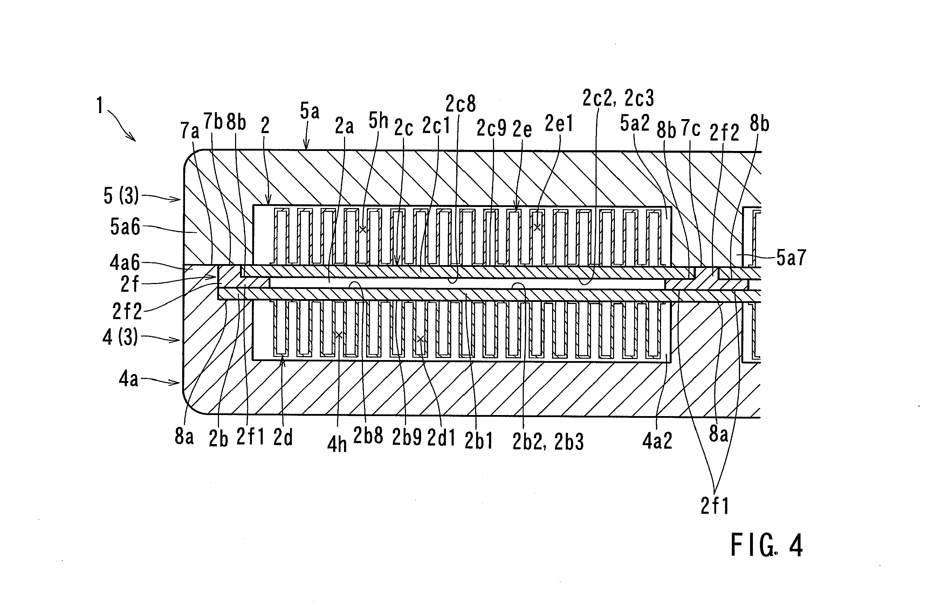

As shown in Fig. 4, the thermoelectric conversion module 2 has thermoelectric conversion elements 2a, substrates 2b and 2c, and fins 2d and 2e. The thermoelectric conversion element (Peltier element) 2a is formed by different metals, such as conductors, or semiconductors. By passing a DC current through it, the thermoelectric conversion element 2a provides a Peltier effect. Two heat surfaces exist in the thermoelectric conversion element 2a. One surface serves to absorb heat while the other serves to radiate heat. A plurality of thermoelectric conversion elements 2a are provided between the substrates 2b and 2c.

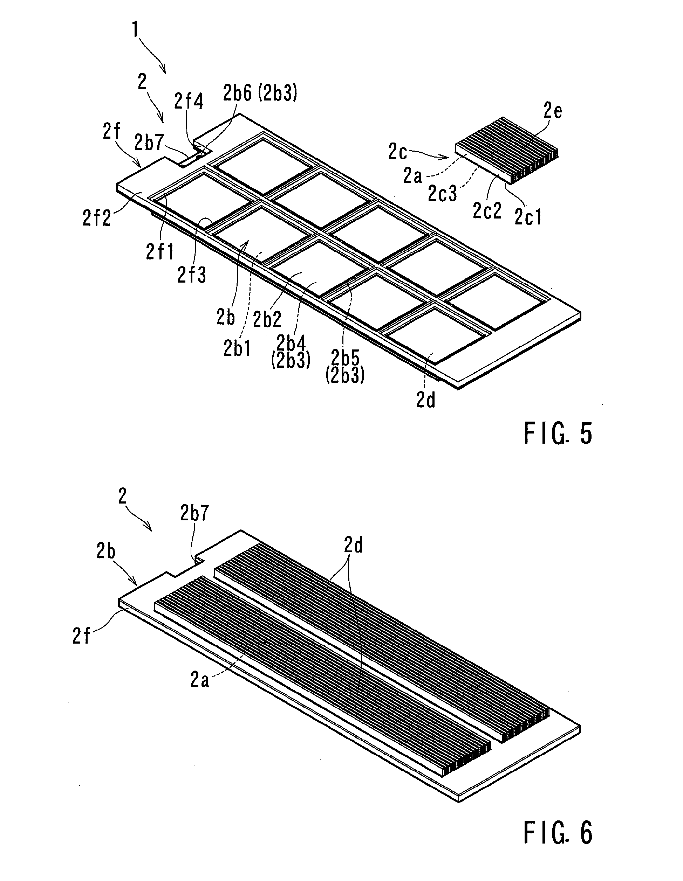

Fig. 6 shows an inverted bottom half of the Peltier module 2, shown in Fig. 3. As shown in Figs. 3 and 6, the first substrate 2b is installed in the inner periphery of the peripheral wall portion 4a6 of the first case 4. The first substrate 2b has a recess 2b7 where the positioning portion 4a9 is installed. Thus, the first substrate 2b is set in position with respect to the first case 4 by the recess 2b7 and the outer peripheral edge. The first substrate 2b covers the open portion of a recess 4h of the first case 4 and forms a flow path 4a2 in cooperation with the case main body 4a.

As shown in Figs. 3, 5 and 6, the second substrates 2c may be smaller than the first substrate 2b. A plurality of (e.g., ten) second substrates 2c is provided in this embodiment. The second substrates 2c are set in position in a predetermined region by a frame member 2f provided on the first substrate 2b. The second substrates 2c and the frame member 2f are covered with the second case 5. The second substrates 2c and the frame member 2f cover an open portion of the recess 5h of the second case 5 and form the flow path 5a2 in cooperation with the case main body 5a.

As shown in Figs. 5 and 9, the substrates 2b and 2c have plate main bodies 2b1 and 2c1, insulation layers 2b2 and 2c2, and sets of wiring 2b3 and 2c3. The plate main bodies 2b1 and 2c1 are formed of a metal material having conductivity. As shown in Figs. 4 and 9, the plate main bodies 2b1 and 2c1, respectively, have inner surfaces 2b8 and 2c8. The outer surfaces 2b9 and 2c9 face the recesses 4h and 5h. The inner surfaces 2b8 and 2c8 are provided with insulation layers 2b2 and 2c2 and sets of wiring 2b3 and 2c3. The insulation layers 2b2 and 2c2 electrically insulate the plate main bodies 2b1 and 2c1 and the sets of wiring 2b3 and 2c3.

Referring to Fig. 5, the sets of wiring 2b3 and 2c3 are formed of a conductive material and are applied (printed on) to the surfaces of the insulation layers 2b2 and 2c2. The thermoelectric conversion elements 2a are held in contact with and soldered to the sets of wiring 2b3 and 2c3. The sets of wiring 2b3 and 2c3 cooperate to connect the plurality of thermoelectric conversion elements 2a in series. Thus, an electric current sequentially flows through the thermoelectric conversion elements 2a in the thickness direction of the substrates 2b and 2c, and between the substrates 2b and 2c in a zigzag fashion.

As shown in Fig. 5, the wiring 2b3 provided on the first substrate 2b has main wirings 2b4, connection wirings 2b5 and end portions 2b6. Each of the main wirings 2b4 is formed in each region covered with the second substrates 2c, with the thermoelectric conversion elements 2a being soldered to the main wiring 2b4 (the main wiring is not distinctly shown in Fig. 5 but exists substantially on the insulation layer 2b2). Each of the connection wirings 2b5 extends to connect the main wirings 2b4. Each of the connection wirings 2b5 is covered with the frame member 2f, and is prevented from coming into contact with the heat medium by the frame member 2f. The end portion 2b6 extends to the exterior of the frame member 2f from one of the connection wiring 2b5. Each of the electrode members 6 is electrically connected to each of the end portions 2b6 (See Fig. 8).

As shown in Figs. 3 and 6, the first substrate 2b is provided with two first fins 2d. Meanwhile, each second substrate 2c is provided with one second fin 2e. The fins 2d and 2e protrude from the substrates 2b and 2c in the direction opposite the thermoelectric conversion elements 2a and are installed in the flow paths 4a2 and 5a2. As shown in Fig. 4, the fins 2d and 2e are of a plate-like and zigzag configuration, with gaps 2d1 and 2e1 being formed between the zigzag turns. The gaps 2d1 and 2e1 extend in the longitudinal direction of the flow paths 4a2 and 5a2 so as not to cut off the flow paths 4a2 and 5a2.

As shown in Fig. 4, the frame member 2f has a frame main body 2f2 and a protruding portion 2f1. The frame main body 2f2 extends along the outer periphery of the second substrates 2c to determine the positions of the second substrates 2c. The frame main body 2f2 extends from the first substrate 2b to protrude toward the second case 5. The protruding portion 2f1 protrudes between the substrates 2b and 2c from the frame main body 2f2 and abuts the substrates 2b and 2c. The frame member 2f is bonded to the first substrate 2b via adhesion or is integrated with the first substrate 2b at the time of molding.

As shown in Fig. 4, a liquid gasket 8b is provided between the protruding portion 2f1 and the outer peripheral portion of the second substrate 2c. The liquid gasket 8b suppresses the heat medium between the protruding portion 2f1 and the second substrate 2c and prevents it from flowing towards the thermoelectric conversion elements 2a. A liquid gasket 8a is provided between the outer peripheral portion of the first substrate 2b and the first case 4. The liquid gasket 8a suppresses the heat medium between the first substrate 2b and the first case 4 and prevents it from flowing towards the thermoelectric conversion elements 2a.

As shown in Fig. 4, the cases 4 and 5 and the frame member 2f are bonded together by fusion bonding portions 7a, 7b and 7c. The fusion bonding portions 7a, 7b and 7c are formed to create oscillation fusion bonding or heat plate fusion bonding between the cases 4 and 5 and the frame member 2f. The fusion bonding portion 7a fusion-bonds the peripheral wall portions 4a6 and 5a6 of the cases 4 and 5. The fusion bonding portion 7a effects sealing between the cases 4 and 5 by fusion bonding the entire peripheries of the outer peripheral portions of the cases 4 and 5. In this way, the fusion bonding portion 7a can suppress intrusion of atmospheric air between the cases 4 and 5. The fusion bonding portion 7b effects fusion bonding between the peripheral wall portion 5a6 and the frame main body 2f2. The fusion bonding portion 7c effects fusion bonding between the partition portion 5a7 and the frame main body 2f2. The fusion bonding portions 7b and 7c effect sealing between the second case 5 and the frame member 2f.

As shown in Fig. 4, the cases 4 and 5 hold the thermoelectric conversion module 2 from both sides. The fusion bonding portion 7a diminishes the gap between the cases 4 and 5. The fusion bonding portions 7b and 7c diminish the gap between the cases 4 and 5 and the thermoelectric module 2. As a result, the cases 4 and 5 hold the substrates 2b and 2c of the thermoelectric conversion module 2 without having to impart a large force. This makes it possible to prevent separation of the substrates 2b and 2c from the thermoelectric conversion elements 2a.

As shown in Figs. 8 and 9, the case 4 is provided with electrode members 6. The electrode members 6 are formed of a conductive metal material in a bar-like configuration. The electrode members 6 are insert-molded with respect to the case 4. Each electrode member 6 integrally has an embedded portion 6a, a first end portion 6b, a second end portion 6c and a connection portion 6d. The embedded portion 6a has a first portion 6a1 extending in a longitudinal direction of the case main body 4a, and a second portion 6a2 extending in an orthogonal direction from the first portion 6a1. The first end portion 6b protrudes from the case main body 4a to extend through the connection portion 4g. The first end portion 6b is electrically connected to a connector inserted into the connector portion 4g. The connector serves to electronically connect the first end portion 6b and the converter.

As shown in Figs. 8 and 9, the second end portion 6c extends in the recess 2b7 and extends upward beyond the surface of the first substrate 2b. A bending portion 6e is formed between the second end portion 6c and the connection portion 6d. The bending portion 6e has a groove, which makes it easy for the bending portion 6e to be bent. The bending portion 6e is bent during a manufacturing process. In the manufacturing process, the connection portion 6d is bent from a manufacturing process position indicated by a phantom line to a use position indicated by a solid line in Fig. 9.

As shown in Fig. 9, while in the manufacturing process position, the connection portion 6d stands in the open position whereby it allows for the insertion of a first substrate 2b into the first case 4. After the first substrate 2b has been set in the first case 4, the bending portion 6e is bent, moving the connection portion 6d from the manufacturing process position to the use position. In the use position, the connection portion 6d is soldered to the wiring 2b3.

The thermoelectric conversion unit 1 is electrically connected to the converter (not shown), and is connected to the sets of piping 21 and 22 as shown in Fig. 1. The converter supplies an electric current to the thermoelectric conversion elements 2a via the electrode members 6 shown in Fig. 9. Each thermoelectric conversion element 2a absorbs heat at its first heat surface; as shown in Fig. 4, it supplies cool heat to the first case via the first substrate 2b and the first fin 2d. Each thermoelectric conversion element 2a radiates heat at its second heat surface, supplying warm heat to the first case 4 via the second substrate 2c and the second fin 2e.

As shown in Fig. 1, the first heat medium is supplied to the first case 4 via the piping 21 by the pump 13. The first heat medium is introduced into the flow path 4a2 from the introduction pipe 4b shown in Fig. 3 and is discharged from the discharge pipe 4c. By flowing through the flow path 4a2, the first heat medium is cooled by thermoelectric conversion elements 2a via the first fin 2d and the first substrate 2b (See Fig. 4).

As shown in Fig. 1, the second heat medium is supplied to the second case 5 via the piping 22 by the pump 15. The second heat medium is introduced into the flow path 5a2 from the introduction pipe 5b shown in Fig. 3 and is discharged from the discharge pipe 5c. By flowing through the flow path 5a2, the second heat medium receives warm heat from the thermoelectric conversion elements 2a via the second fin 2e and the second substrates 2c (See Fig. 4). As shown in Fig. 1, by flowing through the indoor warm/cool unit 14, the second heat medium supplies warm heat to the air in the room.

As shown in Fig. 3, the flowing direction of the first heat medium in the first case 4 and the flowing direction of the second heat medium in the second case 5 are opposite to each other. Thus, the temperature difference between the heat absorbing side and the heat radiating side of the thermoelectric conversion elements 2a is small near the thermoelectric conversion elements 2a. Thus, the thermoelectric conversion module 2, as a whole, exhibits high thermal efficiency.

As described above, as shown in Fig. 3, the thermoelectric conversion unit 1 has a case 4 in which the flow path 4a2 of an open structure is molded. The first substrate 2b covers the open portion of the flow path 4a2. The second substrates 2c are arranged opposite the first substrate 2b. A plurality of thermoelectric conversion elements 2a are arranged between the first substrate 2b and the second substrates 2c. At the bottom surface of the flow path 4h of the case 4, the introduction pipe 4b and the discharge pipe 4c are formed integrally with the case 4. The introduction pipe 4b and the discharge pipe 4c extend in a direction perpendicular to the first substrate 2b.

Accordingly, in the case 4, the opening direction of the flow path 4a2, and the extending direction of the introduction pipe 4b and the discharge pipe 4c are the same. Thus, the case 4 can be molded through the opening and closing of a pair of molds without having to use a slide mold. Thus, the case 4 can be easily manufactured. The heat medium introduced into the flow path 4a2 from the introduction pipe 4b flows toward the first substrate 2b. The heat medium increases in flow rate in the vicinity of the first substrate 2b near the thermoelectric conversion elements 2a, making it possible to efficiently perform heat exchange with the thermoelectric conversion elements 2a.

As shown in Figs. 3 and 7, on the bottom surface of the flow path 4a2, there is formed a protrusion 4f adjacent to the introduction pipe 4b and protruding toward the first substrate 2b. Accordingly, the heat medium introduced into the case 4 from the introduction pipe 4b can flow towards the first substrate 2b via the protrusion 4f. The heat medium increases in flow rate in the vicinity of the first substrate 2b near the thermoelectric conversion elements 2a, making it possible to efficiently perform heat exchange with the thermoelectric conversion elements 2a.

As shown in Figs. 3 and 7, the protrusion 4f has an inclined surface extending away from the introduction pipe 4b. Accordingly, the heat medium can smoothly flow from the introduction pipe 4b toward the first substrate 2b due to the inclined surface. Thus, it is possible to achieve a reduction in pressure loss.

As shown in Fig. 3, the thermoelectric conversion unit 1 has the first case 4 having the first flow path 4a2, with the first case 4 integrally having the first introduction pipe 4b and the first discharge pipe 4c. The thermoelectric conversion unit 1 has the second case 5 having the second flow path 5a2 of an open structure and molded. The open portion of the second flow path 5a2 is covered by the second substrate 2c. On the bottom surface of the second flow path 5a2 of the second case 5, the second introduction pipe 5b and the second discharge pipe 5c are integrally formed. The second introduction pipe 5b and the second discharge pipe 5c extend in a direction perpendicular to the second substrates 2c.

Accordingly, one end portion of each thermoelectric conversion element 2a performs heat exchange with the heat medium in the flow path of the first case 4 via the first substrate 2b. The other end portion can perform heat exchange with the heat medium in the flow path of the second case 5 via the second substrate 2c. As in the case of the first case 4, the second introduction pipe 5b and the second discharge pipe 5c can be formed integrally provided in the second case 5. Further, as in the case of the first case 4, the heat medium flowing through the second case 5 can efficiently undergo heat exchange with the second substrates 2c.

A method of manufacturing the thermoelectric conversion unit 1 includes the steps of: (1) integrally molding the case 4, the introduction pipe 4b, and the discharge pipe 4c by pouring resin between a pair of closed molds and opening the pair of molds; and (2) mounting the first substrate 2b, the second substrates 2c, and the plurality of thermoelectric conversion elements 2a to the case 4. Thus, the case 4, the introduction pipe, and the discharge pipe can be molded easily and integrally through the opening and closing of a pair of molds.

While the invention has been described with reference to specific configurations, it will be apparent to those skilled in the art that many alternatives, modifications and variations may be made without departing from the scope of the present invention. Accordingly, the present invention is intended to embrace all such alternatives, modifications and variations that may fall within the spirit and scope of the appended claims. For example, the present invention should not be limited to the representative configurations.

The heat exchange system 10 may be used for either the heating of a vehicle room or the air conditioning thereof. In the case where the heat exchange system is used for air conditioning, the first case 4 and the piping 22 are connected together and the second case 5 and the piping 21 are connected together.

The heat exchange system 10 may be used for the heating and air conditioning of a vehicle room, the cooling or heating of a vehicle component such as a battery, or the cooling or heating of a product other than a vehicle.

The heat medium supplied into the cases 4 and 5 may be any composition capable of thermal transmission. Preferred compositions include liquids and gases.

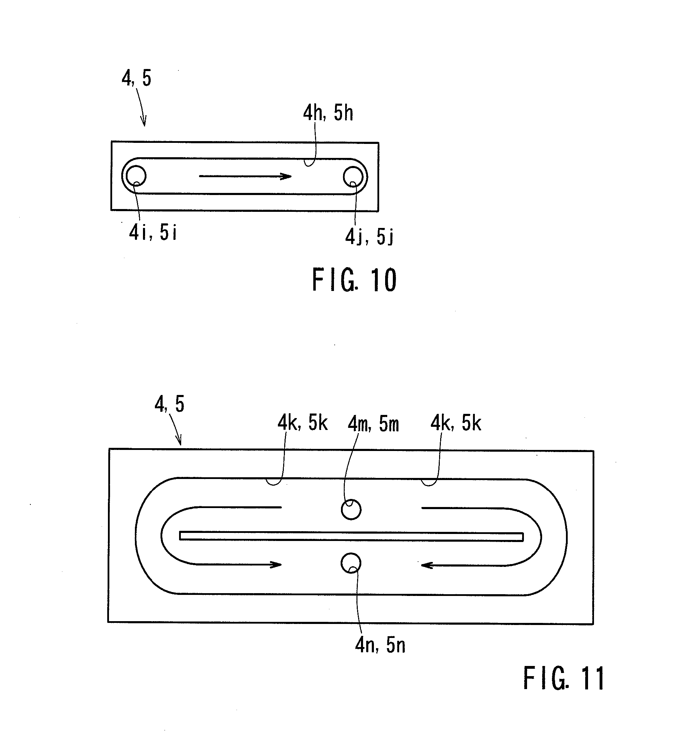

The cases 4 and 5 may have the flow paths 4a2 and 5a2 extending in a variety of shapes. For example, relatively linear flow paths 4h and 5h are shown in Fig. 10. There may be provided introduction pipes having introduction paths 4i and 5i extending from one end portion of the flow paths 4h and 5h, and discharge pipes having discharge paths 4j and 5j extending from the other end portion of the flow paths 4h and 5h.

Alternatively, as shown in Fig. 11, the cases 4 and 5 may have introduction paths 4m and 5m and discharge paths 4n and 5n. Flow paths 4k and 5k extend between the introduction paths 4m and 5m and the discharge paths 4n and 5n in a U-shape direction.

In the first case 4, the case main body 4a and the connector portion 4g may be separately or integrally connected. Alternatively, the connector portion may be provided on the second case instead of on the first case.

The connector portion 4g of the first case 4 may be formed by a slide mold, or may be of a configuration which is open in the mold opening direction so that it can be molded through opening and closing of the first and second molds.

The thermoelectric conversion elements 2a may be Peltier elements providing the Peltier effect, or elements providing the Seebeck effect or the Thomson effect.
One aspect of the present invention includes a thermoelectric conversion unit (1) having a case (4) in which a flow path (4a2) of an open structure is molded, a first substrate (2b) covering an open portion of the flow path (4a2), a second substrate (2c) arranged opposite the first substrate (2b), and a plurality of thermoelectric conversion elements (2a) arranged between the first substrate (2b) and the second substrate (2c). At a bottom surface of the flow path (4a2) of the case (4), an introduction pipe (4b) and a discharge pipe (4c) are formed integrally with the case (4), and each of the introduction and discharge pipes (4b, 4c) extend in a direction perpendicular to the first substrate (2b).

## Claims

1. A thermoelectric conversion unit (1) comprising:
a case (4);
a flow path (4a2) molded into the case (4), the flow path (4a2) having an open structure;
a first substrate (2b) covering an open portion of the flow path (4a2);
a second substrate (2c) arranged opposite the first substrate (2b); and
a plurality of thermoelectric conversion elements (2a) arranged between the first substrate (2b) and the second substrate (2c),
wherein an introduction pipe (4b) and a discharge pipe (4c) are formed integrally with the case (4) at a bottom surface of the flow path (4a2) of the case (4), and the introduction pipe (4b) and the discharge pipe (4c) extend in a direction perpendicular to the first substrate (2b).

2. The thermoelectric conversion unit (1) as in claim 1, wherein there is formed a protrusion (4f) adjacent to the introduction pipe (4b) and protruding toward the first substrate (2b) on the bottom surface of the flow path (4a2).

3. The thermoelectric conversion unit (1) as in claim 2, wherein the protrusion (4f) comprises an inclined surface extending away from the introduction pipe (4b).

4. The thermoelectric conversion unit (1) as in one of claims 1 to 3, wherein:
the case (4) is a first case (4);
the flow path (4a2) is a first flow path (4a2);
the introduction pipe (4b) is a first introduction pipe (4b);
the discharge pipe (4c) is a first discharge pipe (4c); and
the thermoelectric conversion unit (1) further comprises,
a second case (5) comprising a second flow path (5a2),
the second flow path (5a2) being molded into the second case (5),
the second flow path (5a2) having an open structure, and
a second substrate (2c) covering an open portion of the second flow path (5a2),
wherein a second introduction pipe (5b) and a second discharge pipe (5c) are formed integrally with the second case (5) at a bottom surface of the second flow path (5a2) of the second case (5), and the second introduction pipe (5b) and the second discharge pipe (5c) extend in a direction perpendicular to the second substrate (2c).

5. A method of manufacturing the thermoelectric conversion unit (1) as in claim 1 comprising:
a step of integrally molding the case (4; 5), the introduction pipe (4b; 5b), and the discharge pipe (4c; 5c) by pouring resin between a pair of closed molds and opening the pair of molds; and
a step of mounting the first substrate (2b), the second substrate (2c), and the plurality of thermoelectric conversion elements (2a) to the case (4; 5).
